# EUROPEAN PATENT APPLICATION

(11) **EP 0 989 600 A2**
(43) Date of publication of application: **29.03.2000**
(21) Application number: 99118867.3
(22) Date of filing: 24.09.1999
(51) Int. Cl.: H01L 21/465

(54) **Surface cleaning method for manufacturing II-VI compound semiconductor epitaxial wafers**

(30) Priority: 25.09.1998 JP 28890298
(71) Applicant: Sumitomo Electric Industries, Ltd., Osaka-shi, Osaka 541-0041 (JP)
(72) Inventor: Matsuoka, Toru, 1-3, Shimaya 1-chome, Konohana-ku, Osaka (JP); Doi, Hideyuki, 1-3, Shimaya 1-chome, Konohana-ku, Osaka (JP)
(74) Representative: Grünecker, Kinkeldey, Stockmair & Schwanhäusser Anwaltssozietät

(57) **Abstract**

The present invention provides a surface cleaning method of a II-VI compound semiconductor substrate wherein the density of crystal defects newly generated on the surface of the substrate when the epitaxial layer is grown which extend a large negative influence on the properties of a semiconductor device can be reduced, and wherein the surface of the substrate is mirror-like and exceedingly smooth and clean.

This method comprises a process for removing the damaged layer on the surface of a II-VI compound semiconductor substrate and a process for etching the surface of the compound semiconductor substrate from which the damaged layer has been removed within a range of 0.01 to 3µm using an etchant that contains at least Potassium dichromate, Sulfuric acid, and water.

## Description

### BACKGROUND OF THE INVENTION

### (i) Field of the Invention

The present invention relates to an epitaxial wafer and its manufacturing method as well as a surface cleaning method for a compound semiconductor substrate used in the epitaxial wafer, and in particular to an epitaxial wafer having a II-VI compound semiconductor substrate used in a semiconductor device such as a light emitting device and its manufacturing method as well as a surface cleaning method for the substrate.

### (ii) Description of Related Art

In general, II-VI compound semiconductor substrates are formed into substrates by slicing from bulk crystals and polishing. At that time, a layer with poor crystalline quality, called a "damaged layer," is generated. It is necessary to remove this damaged layer on the surface of the substrate through a cleaning process before growing the epitaxial layer.

Conventionally, as disclosed in Article 1 (The Japan Society of Applied Physics and Related Society, Extended Abstracts, 44^{th} Spring Meeting, 1997, p.273, 29a-P-4) and Article 2 (Japanese Patent Laid-Open Publication No. 7-307528), an etching method using an etchant comprising Potassium dichromate, Sulfuric acid, and water has been used as a wet surface cleaning method for II-VI compound semiconductor substrates, for example, a ZnSe substrate.

It is known that in a light emitting device such as a laser diode, for example, among semiconductor devices, crystal defects within the structure of the device have a bad effect on the properties of the device, such as its lifetime.

However, when the layer structure of a device is formed by a method such as molecular beam epitaxy (MBE) on a II-VI compound semiconductor substrate, the surface of which has been cleaned by a conventional method like that mentioned above, crystal defects such as dislocations are newly generated at a high density at the interface between the substrate and the II-VI compound semiconductor epitaxial layer grown on the substrate, thereby greatly damaging the properties of the device. For example, in the case of ZnSe, dislocations of greater than 10⁴cm⁻² are newly generated on the surface of the substrate.

### SUMMARY OF THE INVENTION

The purpose of the present invention is to solve the above problems and to provide a method for cleaning the surface of a II-VI compound semiconductor substrate, which method enables to produce a mirror-like surface which is exceedingly smooth and clean and to reduce, when an epitaxial layer is grown, the density of crystal defects which have a great, negative influence on the properties of a semiconductor device.

A further purpose of the present invention is to provide an epitaxial wafer wherein the density of dislocations newly generated on the substrate surface has been reduced by manufacturing the epitaxial wafer using this surface cleaning method for a compound semiconductor substrate.

The surface cleaning method for a compound semiconductor substrate according to the present invention comprises a process for removing the damaged layer on the surface of a II-VI compound semiconductor substrate and a process for etching the surface of a compound semiconductor substrate using an etchant.

In the present invention, a wet etching method using such etchants as an etchant composed of Potassium dichromate, Sulfuric acid, and water, an etchant composed of hydrogen peroxide and Ammonia solution, or an etchant composed of hydrogen peroxide and Sulfuric acid is given as the method of removing the damaged layer from the surface of the compound semiconductor substrate. Dry etching can also be performed using a reactive gas containing Halogen. It is also possible to remove the damaged layer by a physical method; removal of the damaged layer is not limited to a wet etching.

Further, in the present invention, when etching the surface of the compound semiconductor substrate, the damaged layer of which has been eliminated, it is preferable to use, as the etchant, an aqueous solution containing Sulfuric acid at a ratio of 60 to 98% by weight or preferably 80 to 96% by weight, and Potassium dichromate from 0.1% by weight to saturation.

This is because if an etchant containing Sulfuric acid at a ratio of less than 60% by weight is used, the surface of the substrate may become rough or pits may be observed on the surface of the substrate though a mirror-like surface is obtained, or the surface may become so rough that a mirror-like surface can not be attained. On the other hand, if an etchant with a Sulfuric acid with more than 98% by weight is used, either a mirror-like surface is obtained but micro-pits are generated on the surface of the substrate, or a mirror-like surface can not be obtained because VI elements deposit on the surface. If an etchant containing Potassium dichromate at a ratio of less than 0.1% by weight is used, the etching speed becomes extremely slow, and hence it is not suitable for practical use.

In the present invention, when etching the surface of the compound semiconductor substrate, the damaged layer of which has been removed, the surface of the compound semiconductor substrate should be removed through etching by a thickness in the range of 0.01 to 3µm, or preferably 0.01 to 1µm.

If more than 3µm are removed by etching, the substrate surface will become very rough and when the epitaxial layer is grown the density of dislocations newly generated on the substrate surface will increase. If less than 0.01µm is removed by etching, the reproducibility of the surface morphology of the substrate after etching is poor.

In the present invention, the same etchant can be used for etching in both the process for removing the damaged layer of the surface of the compound semiconductor substrate and the process for etching the surface of the compound semiconductor substrate in which the damaged layer has been removed. However, in this case, it is preferable that after etching to remove the damaged layer is performed, the etching process should be interrupted briefly and after washing the surface of the substrate with water or other solvents, the etching should be resumed.

In the present invention, the II-VI compound semiconductor substrate crystals include ZnSe. The present invention also includes the manufacturing method of an epitaxial wafer in which an epitaxial layer is formed on a compound semiconductor substrate, the surface of which has been cleaned by one of the above methods. Further, the present invention also includes an epitaxial wafer which comprises a II-VI compound semiconductor substrate and an epitaxial layer formed on the compound semiconductor substrate and in which the density of dislocations newly generated on the surface of the compound semiconductor substrate is less than 10⁴cm⁻².

As described above, a substrate with an exceedingly smooth and clean surface can be obtained by a surface cleaning method according to the present invention. By forming a II-VI compound semiconductor epitaxial layer on a substrate, the surface of which has been cleaned in this way, the density of dislocations newly generated on the substrate surface remains below 10⁴cm⁻², and a II-VI compound semiconductor thin film with low defect density can be formed.

As a result, according to the present invention, improvement of II-VI compound semiconductor device properties, beginning with improvement of the lifetime of light emitting devices such as laser diodes or light emitting diodes can be promoted.

### BRIEF DESCRIPTION OF THE DRAWINGS

Figure 1 is a picture showing the etch pits of a ZnSe substrate before removing the damaged layer.
Figure 2 is a picture showing the etch pits of a ZnSe substrate after removing the damaged layer.
Figure 3 is a cross-section of an epitaxial wafer.
Figure 4 is a graph showing the relationship between the etching depth, which is the thickness etched, and the surface roughness of the ZnSe substrate.
Figure 5 is a graph showing the relationship between the etching depth and the density of dislocations in the ZnSe film newly generated on the surface of the substrate.
Figure 6 is a schematic diagram showing the etching process of a ZnSe substrate using an etchant composed of Potassium dichromate, Sulfuric acid, and water.
Figure 7 shows the surface morphology of the substrate after etching.
Figure 8 shows the surface morphology of the substrate after etching.
Figure 9 shows the surface morphology of the substrate after etching.
Figure 10 shows the surface morphology of the substrate after etching.
Figure 11 shows the surface morphology of the substrate after etching.

### DETAILED DESCRIPTION OF THE PREFERRED EMBODIMENT

For manufacturing a high quality epitaxial wafer having a II-VI compound semiconductor epitaxial thin film on a II-VI compound semiconductor substrate, the following experiments were performed in order to examine in particular the optimum conditions for a surface cleaning method of the substrate.

### (Example 1)

A ZnSe substrate was produced by slicing from a ZnSe bulk crystal and polishing. The surface plane of the substrate was (100).

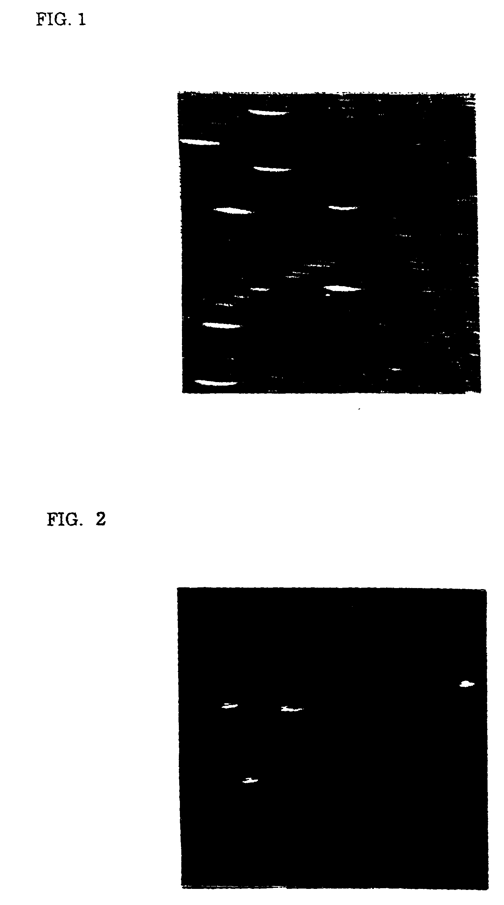

Figure 1 shows the etch pits of a ZnSe substrate before removing the damaged layer. The etch pits were formed by using a bromine-methanol solution.

Referring to Fig. 1, many long and thin etch pits can be seen on the surface of the ZnSe substrate. These long and thin etch pits correspond to dislocations on the substrate.

Aside from the dislocations on the substrate, defects on the ZnSe substrate can be observed ranging like a belt from the upper center of the picture to the lower right and also from the lower left to the upper right. These defects indicate the existence of a damaged layer on the substrate surface generated by the process of slicing the substrate off the bulk crystal and polishing.

If a ZnSe epitaxial layer is grown on the substrate without removing the damaged layer, the crystalline quality of the epitaxial layer will become poor. Thus, in order to remove the damaged layer, the surface of the ZnSe was etched by a thickness of 5µm using an etchant comprising Potassium dichromate, Sulfuric acid, and water.

Figure 2 shows the etch pits of the ZnSe substrate after removing the damaged layer by etching. As in Fig. 1, the etch pits were formed by using a bromine-methanol solution.

Referring to Fig. 2, long, thin etch pits can be seen on the surface of the substrate corresponding to dislocations, but defects, such as ranging like a belt, corresponding to the damaged layer can not be seen. Accordingly, we know that the damaged layer was completely removed by etching the surface of the substrate by 5µm.

However, because the thickness of the damaged layer differs depending on the conditions of slicing and polishing, the etching thickness is not definitely limited to 5µm, but should be set to a thickness that is suitable for removing the damaged layer completely.

Next, the ZnSe substrate after removing the damaged layer was loaded into a thin film growth chamber at 1x10⁻¹⁰ Torr, and after hydrogen plasma cleaning for 30 minutes at 350°C, a ZnSe epitaxial layer was grown on the substrate by MBE.

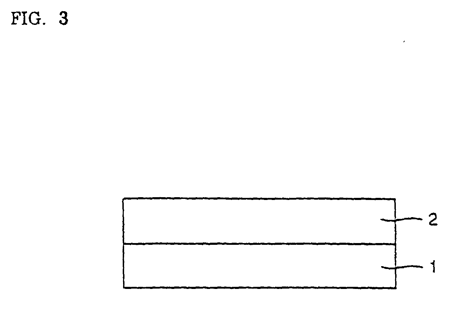

Figure 3 is a cross-section showing the structure of an epitaxial wafer produced as mentioned above.

As shown in Fig. 3, in this epitaxial wafer, a ZnSe epitaxial layer 2 was formed on the ZnSe substrate 1.

When the density of dislocations in this epitaxial wafer was measured, it was found that the density of dislocations newly generated on the surface of the substrate was 3x10⁴cm⁻². In this specification, "density of dislocations newly generated in the surface of the substrate" shall mean the density of dislocations newly generated at the substrate/epitaxial layer interface, and not including any dislocations penetrated from the substrate.

Next, according to the present invention, 0.5µm-thick etching of the surface of the ZnSe substrate from which the damaged layer had been removed was done by using an etchant comprising Potassium dichromate, Sulfuric acid, and water.

After the ZnSe substrate, the surface of which had been cleaned according to the present invention, was loaded into a thin film growth chamber at 1x10⁻¹⁰ Torr and then irradiated by hydrogen plasma for 30 minutes at 350°C. A ZnSe epitaxial layer was grown on the substrate by MBE and an epitaixial wafer of the structure shown in Fig. 3 was produced.

When the density of dislocations of the epitaxial wafer thus obtained according to the present invention was measured, the density of dislocations newly generated on the surface of the substrate was found to be 3x10³cm⁻², which is less than 10⁴cm⁻².

It is thought that because the surface of the ZnSe substrate was a mirror-like surface of exceeding smoothness and cleanness due to the surface cleaning method of the substrate according to the present invention, when the epitaxial layer was grown, the crystal defects newly generated on the surface of the substrate were reduced.

### (Example 2)

The present inventors performed various examinations of etching conditions when cleaning the surface of the ZnSe substrate under the same conditions as in Example 1. From the results, it was discovered that the flatness of the substrate varies depending on the etching depth when etching the surface of the ZnSe substrate from which the damaged layer has been removed and it also has an effect on the density of dislocations newly generated after formation of the epitaxial layer.

The details are explained below.

Under the same conditions as in Example 1, the damaged layer was removed from the surface of a ZnSe substrate by etching off 5µm using an etchant comprising Potassium dichromate, Sulfuric acid, and water.

After washing the surface of the ZnSe substrate once in water, the surface of the substrate was again etched by various thickness, using an etchant comprising Potassium dichromate, Sulfuric acid, and water.

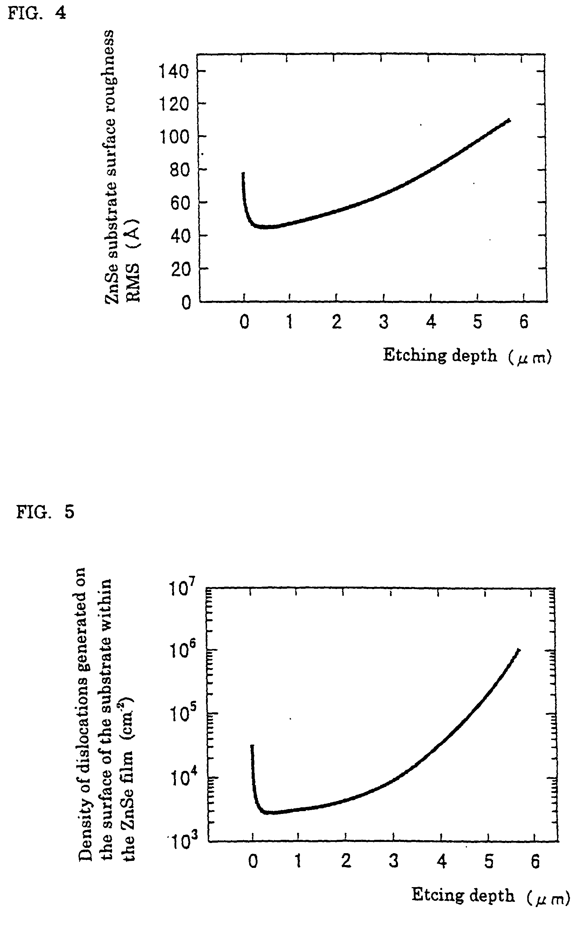

Figure 4 shows the surface roughness of the surface of the ZnSe substrate after etching, measured by atomic force microscopy (AFM). The roughness of the surface is expressed as an RMS value. In Fig. 4, the horizontal axis shows the etching depth (µm), and the vertical axis shows the RMS value (Å), which is the surface roughness of the substrate.

By referring to Fig. 4, it is clear that the RMS value changes depending on the etching depth. Immediately after etching is begun, the RMS value is reduced and the surface of the substrate becomes more smooth, but as the etching depth increases, the RMS value increases. In other words, in order to obtain a mirror-like substrate surface that is very smooth, the etching depth should be no greater than 3µm, or preferably, less than 1µm. On the other hand, at least 0.01µm must be etched off as the lower limit of the etching depth. This is because if the etching depth is too small, the reproducibility of the surface morphology of the substrate after etching is poor.

Next, a ZnSe epitaxial layer was grown on ZnSe substrates from which the surface had been etched by differing depth under the same conditions as in Example 1 and epitaxial wafers were produced.

Figure 5 is a graph showing the density of dislocations newly generated on the surface of the substrates for the epitaxial wafers so obtained. In Fig. 5, the horizontal axis shows the etching depth (µm) which is the thickness etched, and the vertical axis shows the density of dislocations (cm⁻²) in the ZnSe film newly generated on the surface of the substrate.

By referring to Fig. 5, it is clear that the density of dislocations newly generated in the surface of the substrate is lower in the area where the substrate surface is very smooth, as shown in Fig. 4. In other words, when the etching depth is over 0.01 µm and under 3 µm, or preferably under 1 µm, the density of dislocations newly generated on the surface of the substrate is less than 10⁴cm⁻² and it is possible to grow a high quality ZnSe epitaxial layer with low defect density.

The following are thought to be reasons why the flatness of the substrate surface becomes worse and the defect density increases when the etching depth is too deep.

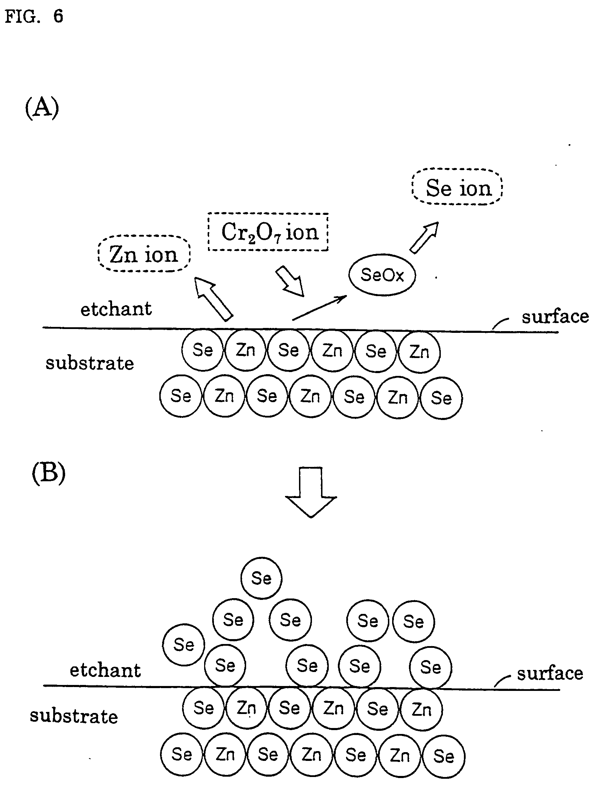

Figure 6 is a schematic diagram when etching the ZnSe substrate using an etchant comprising Potassium dichromate, Sulfuric acid, and water.

First, referring to Fig. 6 (A), when the ZnSe substrate is soaked in the etchant, the zinc becomes zinc ion and dissolves in the etchant. On the other hand, after the Selenium reacts with the dichromate ion (Cr₂O₇) to become Selenium oxide (SeOₓ), it becomes Selenium ion and dissolves in the etchant. Because the oxidative reaction of the Selenium is slow, Se deposits on the substrate surface and the flatness of the surface become worse as shown in Fig. 6 (B).

In this Example, etching was performed with an etchant comprising potassium dichromate, Sulfuric acid, and water in order to remove the damaged layer on the substrate. As a result, it is thought that a large quantity of Se deposited on the surface of the ZnSe substrate directly after removing the damaged layer, as shown in Fig. 6 (B). If etching is continued in this condition however, even more Se will deposit on the surface of the substrate because the oxidative reaction of Se slows down due to the slow diffusion rate of Cr₂O₇ on the surface of the substrate.

According to the present invention, etching must be interrupted once and the surface of the substrate must be washed before etching is resumed. Therefore, because the concentration of Cr₂O₇ on the surface of the substrate becomes sufficiently great, the Se deposited on the surface rapidly oxidizes. Through this rapid oxidation process the Se on the substrate surface dissolves and the smoothness of the substrate surface is improved.

However, if the etching proceeds further, the oxidation reaction rate of Se will again slow down because the diffusion rate of Cr₂O₇ on the substrate surface slows down. As a result, Se will again accumulate on the substrate surface and the flatness of the surface of the substrate will become worse.

### (Example 3)

The inventors next examined the most suitable compositions of the etchant comprising Potassium dichromate, Sulfuric acid, and water for the etching conditions when cleaning the surface of the ZnSe substrate.

First, it was discovered that when the concentration of the Potassium dichromate was less than 0.1% by weight the etching speed becomes extremely slow, and as a result is not suited to practical use.

Thus, etchant was prepared with the concentration of Potassium dichromate within a range from 0.1% by weight to saturation, and etching was performed on the ZnSe substrate surface with the three variations in the concentration of Sulfuric acid: less than 60% by weight (condition A), in the range of 60% to 98% by weight (condition B), and greater than 98% by weight (condition C).

The surface morphology was observed with a Nomarsky microscope after etching off by 0.5 µm.

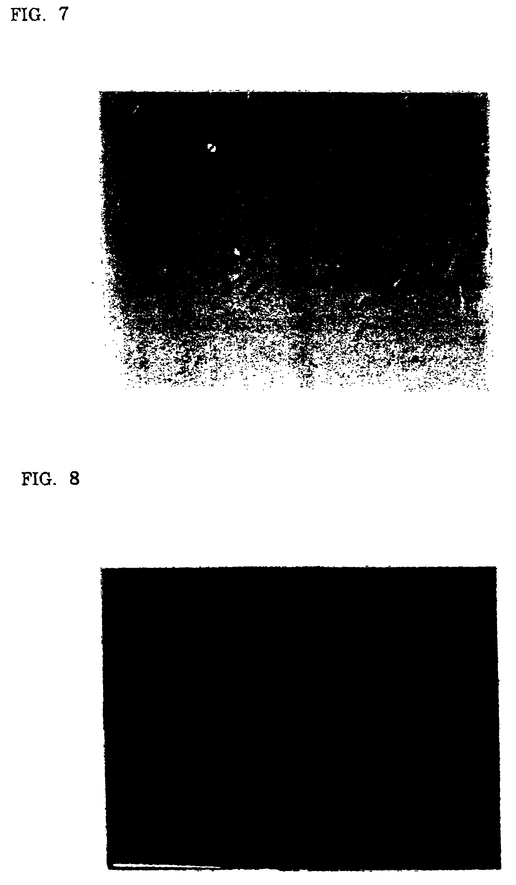

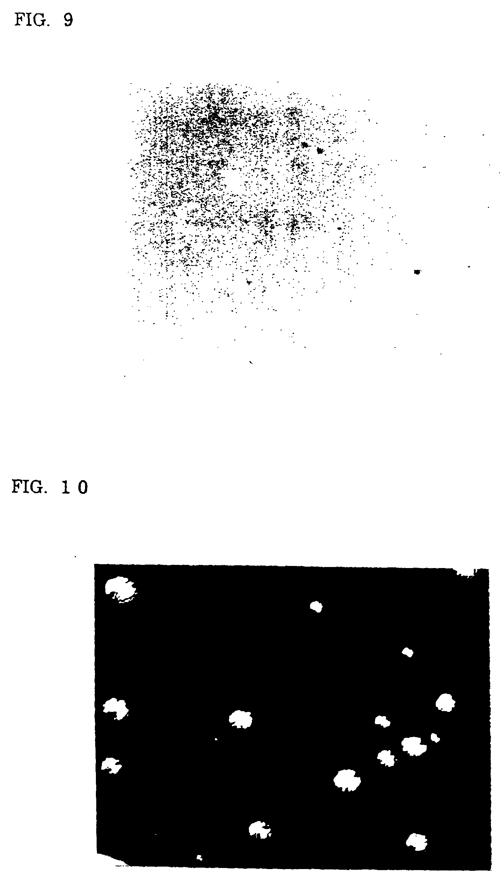

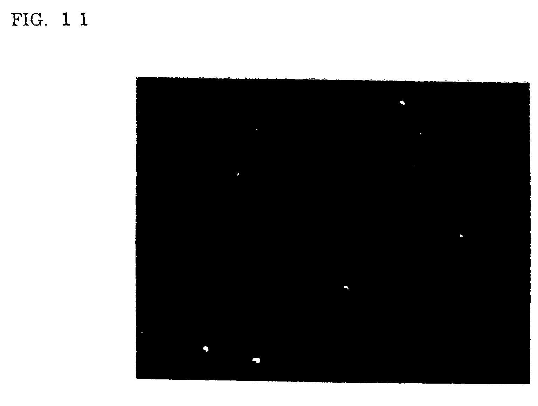

Figures 7 to 11 show the surface morphology observed. Figures 7 and 8 show the results when using a condition A etchant, Fig. 9 shows the results when using a condition B etchant, and Figs. 10 and 11 show the results when using a condition C etchant.

First, when a condition A etchant was used, as shown in Fig. 7, surface roughness was generated and occasionally pits could also be seen. As shown in Fig. 8, there was terrible roughness, and the surface was no longer mirror-like.

When a condition B etchant was used, a smooth surface was obtained as shown in Fig. 9: sometimes minute pits can be seen looking like small white dots, but the surface is mirror-like, there is no background roughness.

When a condition B etchant was used both as the etchant in the process for removing the damaged layer of the substrate surface and as the etchant in the process of etching the surface of the substrate after the damaged layer had been removed, a smooth surface with no roughness and a mirror-like surface was obtained.

When a condition C etchant was used, as shown in Fig. 10, the surface was not mirror-like and Se deposited greatly on the surface and could be observed as white shell shapes. As shown in Fig. 11, though the surface was mirror-like, multiple, miniature pits were generated that can be observed as white dots.

In Figs. 7 to 11 the objects seen as black spots are soiled spots on the microscope, and have no relation to defects of the substrate whatsoever.

Also, a ZnSe substrate was used as an example in the above Examples, but the application of the present invention is not limited to ZnSe substrates: it can be widely applied to II-VI compound semiconductor substrates.

Further, in the above Examples we have described the situation where MBE is used as the method for forming an epitaxial layer on the ZnSe substrate, but the invention is not limited to use of this method, and the same effect can be achieved even when using other methods, such as MOVPE.

## Claims

1. A surface cleaning method of a II-VI compound semiconductor substrate, the surface cleaning method comprising a process of removing a damaged layer of the surface of the substrate and a process of etching the surface of the substrate from which the damaged layer has been removed using an etchant.

2. A surface cleaning method of a substrate according to Claim 1, wherein said etchant contains at least Potassium dichromate, Sulfuric acid, and water.

3. A surface cleaning method of a substrate according to Claim 2, wherein said etchant is an aqueous solution containing Sulfuric acid at a ratio of 60 to 98 % by weight and Potassium dichromate at a ratio from 0.1% by weight to saturation.

4. A surface cleaning method of a substrate according to Claim 2 or 3, wherein said process of etching removes the surface of said substrate by a thickness in the range of 0.01 to 3µm.

5. A surface cleaning method of a substrate according to any of Claims 1 to 4, wherein said process for removing a damaged layer of the surface of the substrate uses an etchant comprising at least Potassium dichromate, Sulfuric acid, and water.

6. A surface cleaning method of a substrate according to Claim 5, wherein said etchant used in said process for removing a damaged layer of the surface of the substrate is an aqueous solution containing 60 to 98% by weight of Sulfuric acid and from 0.1% to saturation of Potassium dichromate.

7. A surface cleaning method of a compound semiconductor substrate according to any of Claims 1 to 6, wherein said substrate is ZnSe.

8. An epitaxial wafer manufacturing method comprising a surface cleaning method of a substrate according to any of Claims 1 to 7 and a process for forming an epitaxial layer on a substrate the surface of which has been cleaned by said surface cleaning method of a substrate.

9. An epitaxial wafer manufactured according to Claim 8, wherein a density of dislocations newly generated on the surface of said substrate is less than 10⁴cm⁻².
